# EUROPÄISCHE PATENTANMELDUNG

(11) **EP 0 979 028 A1**
(43) Veröffentlichungstag der Anmeldung: **09.02.2000**
(21) Anmeldenummer: 98810752.0
(22) Anmeldetag: 05.08.1998
(51) Int. Cl.: H05K 3/10, F04C 9/00, B05C 11/10, H01L 21/00, H05K 13/04, G01F 11/02

(54) **Vorrichtung zur dosierten Abgabe einer hochviskosen Flüssigkeit**

(71) Anmelder: ESEC Management SA, 6330 Cham (CH); ESEC SA, CH-6330 Cham (CH)
(72) Erfinder: Stalder, Roland, 8050 Zürich (CH); Koster, Christof, 6319 Allenwinden (CH); Schmalz, Peter, 6280 Hochdorf (CH)

(57) **Zusammenfassung**

Eine Vorrichtung zur dosierten Abgabe einer hochviskosen Flüssigkeit weist einen Ansaugkanal (20), über den die Flüssigkeit zugeführt wird, und einen Abgabekanal (21), über den die Flüssigkeit abgegeben wird, und ein in zwei Stellungen betreibbares Ventil (17) auf. Die Endbereiche (5, 6) eines einzigen Kanals (4) sind mittels des Ventils (17) wechselweise mit dem Ansaugkanal (20) oder dem Abgabekanal (21) verbindbar. Zur dosierten Abgabe der Flüssigkeit ist ein Schieber (2) im Kanal (4) zwischen zwei Positionen (E, F) hin- und her bewegbar. Die Vorrichtung ist bevorzugt auf einem Schreibkopf (24) angebracht.

Die Vorrichtung eignet sich zum Auftragen von Klebstoff auf ein Substrat.

## Beschreibung

Die Erfindung betrifft eine Vorrichtung nach dem Oberbegriff des Patentanspruchs 1.

Eine solche Vorrichtung ist beispielsweise bekannt aus der Patentschrift US 4 485 387. In dieser Schrift ist ein System zum Auftragen einer Dickfilm-Druckfarbe auf ein Substrat beschrieben, bei welchem ein Ansaugkanal und ein Ausstosskanal mit einem quer zu diesen angeordneten Doppelzylinder vorgesehen sind. Über ein Drehventil wird der Ansaugkanal abwechslungsweise mit dem einen Zylinder und gleichzeitig der andere Zylinder mit dem Ausstosskanal verbunden und umgekehrt. In den beiden sich diametral gegenüberliegenden Zylindern sind gegengleich gekoppelte Kolben angeordnet, die von einem Motor ständig hin- und herbewegt werden. Das Ventil wird gleichzeitig im Takt mit der Kolbenbewegung hin- und hergedreht Somit wird im einen Zylinder eine bestimmte Menge an Druckfarbe angesaugt und gleichzeitig im anderen Zylinder die vorher abgemessene Menge an Druckfarbe ausgestossen. Der Hub der Kolben ist einstellbar, so dass die Menge an angesaugter und ausgestossener Druckfarbe nach Bedarf eingestellt werden kann. Uni einen einwandfreien Betrieb der vorliegenden Vorrichtung zu gewährleisten, weist sie relativ grosse Dimensionen und somit ein grosses Gewicht auf. Diese Vorrichtung ist deshalb über lange Schläuche an einen über das Substrat bewegbaren Schreibkopf angeschlossen.

Um integrierte Schaltungen oder IC's mit elektrischen Anschlüssen zu versehen, werden aus einer dünnen Metallplatte mittels eines Rahmens zusammenhängende Anschlussfinger, sogenannte Leadframes, ausgestanzt. Mittels eines sogenannten Die Bonders wird anschliessend die integrierte Schaltung aufgebracht, welche dann auf den Anschlussfingern haftet. Dazu wird für eine bestimmte Grösse der integrierten Schaltungen ein Muster aus Epoxy-Klebstoff auf das jeweilige Leadframe aufgebracht, was mit Vorteil mittels einer oben beschriebenen Vorrichtung geschieht. Da die Epoxy-Klebstoffe oder - Harze je nach Zusammensetzung eine kurze Topfzeit haben, werden mit der Zeit Reste in der Dosiervorrichtung zurückbleiben, so dass sie regelmässig gereinigt werden muss. Zu diesem Zweck muss die Vorrichtung zerlegt und mit einer schmierseifenähnlichen Reinigungpaste (Tenside) durchspült werden. Anschliessend muss die Vorrichtung wieder sorgfältig zusammengebaut werden, was vorallem bei den Dichtungen einiges Geschick braucht. Insbesondere sind die bei der Vorrichtung vorhandenen Stopfbüchsen mit einem Drehmomentschlüssel festzuschrauben. Auch die langen Schläuche zum Schreibkopf sind zu reinigen und gegebenenfalls zu ersetzen. Es versteht sich, dass diese Vorrichtung ziemlich aufwendig und deshalb teuer ist, insbesondere auch in Bezug auf die Antriebe der Kolben.

Aus diesen und anderen Gründen liegt nun der vorliegenden Erfindung die Aufhabe zugrunde, eine Vorrichtung der oben genannten Art so zu verbessern, dass sie ein tieferes Gewicht aufweist, wesentlich einfacher und kostengünstiger hergestellt werden kann und eine einfachere Reinigung möglich ist.

Diese Aufgabe wird durch eine Vorrichtung mit den Merkmalen des Patentanspruchs 1 gelöst.

Mit der erfindungsgemässen Vorrichtung ist eine besonders kleine Bauweise möglich, so dass diese sogar mit dem bewegbaren Schreibkopf zusammengebaut werden kann.

Weitere Vorteile der Erfindung folgen aus den abhängigen Patentansprüchen und aus der nachfolgenden Beschreibung, in welcher die Erfindung anhand eines in den schematischen Zeichnungen dargestellten Ausführungsbeispieles näher erläutert wird. Es zeigen:
- Fig. 1: eine Dosiervorrichtung in Draufsicht,
- Fig. 2: die Dosiervorrichtung in Seitenansicht,
- Fig. 3: die mit einem Ventil ergänzte Dosiervorrichtung in Draufsicht, und
- Fig. 4: die mit dem Ventil ergänzte und auf einem Schreibkopf montierte Dosiervorrichtung in Seitenansicht.

In den Figuren sind für dieselben Elemente jeweils dieselben Bezugszeichen verwendet worden und erstmalige Erklärungen betreffen alle Figuren.

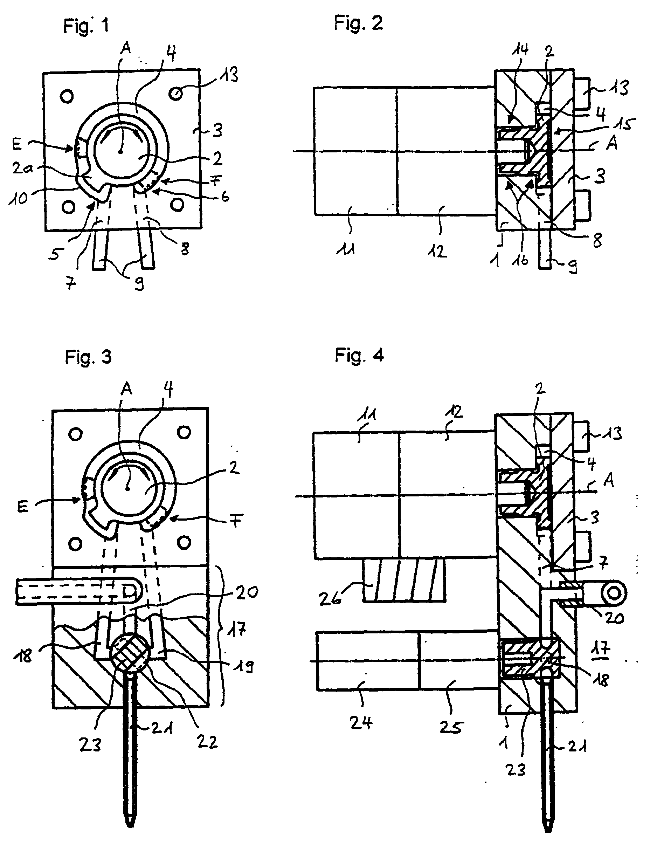

Die Figuren 1 und 2 zeigen in Draufsicht bzw. in Seitenansicht eine Dosiervorrichtung zur dosierten Abgabe einer hochviskosen Flüssigkeit, die einen Körper 1, einen um eine Drehachse A drehbaren Schieber 2 und eine Deckplatte 3 umfasst. Zwischen dem Körper 1 und der Deckplatte 3 ist ein Hohlraum vorhanden, so dass bei eingesetztern Schieber 2 ein kreisrunder Kanal 4 gebildet ist. Der Kanal 4 ist an seinen Endbereichen 5 und 6 über Zufuhrkanäle 7 und 8 mit je einem Anschlussnippel 9 verbunden. Im Kanal 4 ist in der Nähe des einen Endbereiches 5 eine Ausbuchtung 10 vorgesehen, welche zum erstmaligen Füllen des Kanals 4 mit der Flüssigkeit dient. Der Schieber 2 weist einen in den Kanal 4 ragenden Nocken 2a auf mit dem die Flüssigkeit durch den Kanal 4 schiebbar ist.

Derdrehbare Schieber 2 wird von einem Motor 11 bewegt, wobei zwischen den Motor 11 und den Schieber 2 ein untersetzendes Getriebe 12 geschaltet ist. Der Körper 1 und die Deckplatte 3 sind beispielsweise mittels Schrauben 13 odermittels Schnappelementen lösbar miteinander verbunden. Der Körper 1 weist eine Bohrung 14 auf, in die hinein der Schieber 2 unter Anwendung von leichtem Druck steckbar ist. Die gegen die Deckplatte 3 gerichtete Oberfläche des Schiebers 3 ist mit einer Ausnehmung 15 versehen, so dass die Fläche, an der sich die Deckplatte 3 und der Schieber 2 berühren, gering gehalten werden kann und nur so gross ist, wie es für eine ausreichende Dichtung nötig ist Weitere Ausnehmungen 16 am Schieber 2 bewirken, dass auch die Fläche, an der sich der Schieber 2 und der Körper 1 berühren,vergleichsweise klein ist. Die Abmessungen des Schieben 2 sind so gewählt, dass der Schieber 2 im zusammengesetzten Zustand der Dosiervorrichtung zwischen dem Körper 1 und der Deckplane 3 eingeklemmt ist, dabei jedoch bevorzugt von Hand noch drehbar ist. Wegen der kreisförmigen Gestalt des Kanals 4 (Fig. 1) ergibt sich eine kompakte Bauweise der Dosiervorrichtung, derzufolge einerseits die durch den Presssitz des Schiebern 2 bewirkte Dichtung ausreichend ist, damit die Flüssigkeit nicht austreten kann, und derzufolge andererseits die Reibung zwischen dem Schieber 2 und dem Körper 1 sowie der Deckplatte 3 infolge der Ausnehmungen 15 und 16 genügend gering ist, damit der Schieber 2 jeweils mit der erforderlichen Genauigkeit um einen vorbestimmten Winkel φ gedreht werden kann. Es versteht sich von selbst, dass die Ausnehmungen 15 und 16 auch an der Deckplatte 3 bzw. am Körper 1 angebracht sein könnten. Zur Reinigung der Dosiervorrichtung 1 wird die Deckplatte 3 entfernt und der Schieber 2 herausgenommen. Das Getriebe 12 und der Motor 11 kommen mit der zu aufzutragenden Flüssigkeit nicht in Kontakt.

Der Körper 1 und die Deckplatte 3 sind beispielsweise aus Stahl, der Schieber 2 aus Kunststoffgefertigt, damit sich ideale Gleiteigenschaften zwischen dem Schieber 2 und dem Körper 1 sowie der Deckplatte 3 ergeben. Denkbar ist auch, alle diese Teile als Spritzgussteile aus Kunststoffen zu fertigen.

In den Figuren 3 und 4 ist die Dosiervorrichtung in Kombination mit einem Ventil 17 dargestellt, das den fortlaufenden Betrieb der Dosiervorrichtung in beiden Drehrichtungen des Schiebers 2 ermöglicht. Die Dosiervorrichtung und das Ventil 17 sind, wie abgebildet, bevorzugt einstückig ausgebildet, können jedoch auch getrennt sein. Das Ventil 17 ist beispielsweise als Drehventil 17 ausgebildet, das zwei einander diametral gegenüberliegende Verbindungskanäle 18 und 19 und um 90° gedreht dazu einen Ansaugkanal 20 und einen diesem diametral gegenüberliegenden Abgabekanal 21 aufweist. Die Zuführkanäle 7 und 8 gehen direkt in die Verbindungskanäle 18 bzw. 19 über und können sehr kurz gehalten werden. Die Kanäle 18 bis 21 münden alle in eine Sacklochbohrung 22, in welcherein Drehschieber 23 im wesentlichen zwischen zwei Positionen hin- und herbewegbar ist. Der Drehschieber 23 wird von einem Motor 24 betätigt, wobei zwischen den Motor 24 und den Drehschieber 23 ein untersetzendes Getriebe 25 geschaltet ist In der dargestellten ersten Position des Drehschiebers 23 ist der linke Verbindungskanal 18 mit dem Ansaugkanal 20 verbunden und der rechte Verbindungskanal 19 mit dem Abgabekanal 21. Wenn der Drehschieber 23 um 90° in die gestrichelt dargestellte zweite Position gedreht wird, ist dies gerade umgekehrt. Im Betrieb ist der Ansaugkanal 20 mit einem die hochviskose Flüssigkeit enthaltenden Reservoir verbunden. Die so mit dem Drehventil 17 komplettierte Dosiervorrichtung wird bevorzugt auf einem beweglichen Schreibkopf 26 montiert, wobei der Abgabekanal 21 direkt als Schreibdüse ausgebildet ist.

Beim erstmaligen Füllen der Dosiervorrichtung befindet sich der Drehschieber 23 des Drehventils 17 in der in der Figur 3 dargestellten ersten Stellung und der drehbare Schieber 2 der Dosiervorrichtung befindet sich in der in der Figur 1 gezeigten Stellung. Die - hier nicht weiterdargestellte - hochviskose Flüssigkeit wie Epoxy-Klebstoff wird nun unter einem Druck von etwa 5 bar über den linken Verbindungskanal 18 in den kreisrunden Kanal 4 hineingepresst und über den Verbindungskanal 19 aus dem Abgabekanal 21 wieder ausgestossen. Da sich der Schieber 2 in der Ausbuchtung 10 befindet, kann die durch den Zuführkanal 7 unter Druck hineingestossene Flüssigkeit den Schieber 2 problemlos umfliessen und in den Kanal 4 gelangen. Im Zuführkanal 7 vorhandene Luft wird dabei vor der Flüssigkeit hergeschoben und letztendlich überden Abgabekanal 21 aus der Dosiervorrichtung 1 herausbefördert. Besondere Öffnungen wie beim Stand der Technik zur Entlüftung der Dosiervorrichtung, in Fachkreisen mit 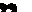 bleeding" bezeichnet, sind nicht erforderlich. Damit werden Luftblasen in der Pumpe automatisch, d.h. ohne dass äussere Manipulationen erforderlich sind, beseitigt.

Sodann wird der drehbare Schieber 2 im Uhrzeigersinn gedreht bis der Nocken 2a eine mit E bezeichnete Position einnimmt Die Dosiervorrichtung ist nun mit der hochviskosen Flüssigkeit gefüllt und bereitzum Dispensen der Flüssigkeit auf das nicht dargestellte Substrat. Bei jedem Dispensvorgang wird der Schieber 2 um einen vorbestimmten Winkel φ gedreht, wobei die Menge des ausgestossenen Klebstoffes proportional zum Winkel φ ist. Nach einer vorbestimmten Anzahl n von Dispensvorgängen befindet sich der Nocken 2a des Schiebers 2 in einer gestrichelt dargestellten Position F. In diesem Zustand wird nun der Drehschieber 23 des Drehventils 17 in seine zweite Stellung bewegt und die Drehrichtung des Schieben 2 umgekehrt. Nach n weiteren Dispensvorgängen erreicht der Schieber 2 deshalb wieder die Position E. Der Schieber 2 wird also zum Aufragen der Flüssigkeit in jeweils n Schritten zwischen den Positionen E und F hin- und herbewegt, wobei jeweils in den Postionen E und F die Stellung des Drehschiebers 23 des Drehventils 17 gewechselt wird. Die grösste Menge an Flüssigkeit wird dann auf das Substrat aufgetragen, wenn n=1 ist.

Ist die mit dem Drehventil 17 komplettierte Dosiervorrichtung auf dem beweglichen Schreibkopf 26 montiert, kann der Weg zwischen dem die aufzutragende Flüssigkeitsmenge bestimmenden Schieber 2 und der Schreibdüse bei dieser Bauart sehr kurz gehalten werden kann. So ergibt sich eine sehr hohe Reproduziergenauigkeit der bei jedem Dispensvorgang ausgestossenen Flüssigkeitsmenge. Befindet sich zwischen dem Abgabekanal 21 und der Schreibdüse ein vergleichsweise langer Schlauch von typisch 300 mm Länge, wie das beim Stand der Technik üblich ist, wo die Dosiervorrichtung nicht auf dem Schreibkopf montiert ist, dann wirkt der mit Flüssigkeit gefüllte Schlauch wegen der Eigenschaften der Flüssigkeit wie ein "Tiefpass" und die Kontrolle der auszustossenden Menge an Flüssigkeit gestaltet sich viel schwieriger.

Es versteht sich für den Fachmann, dass die oben beschriebene Dosiervorrichtung nicht nur mit einem kreisrunden Kanal 4 und einem drehbaren Schieber 2 funktioniert, sondern dass auch ein geradliniger Kanal mit einem darin hin- und herbewegbaren Schieber vorgesehen sein kann.

## Patentansprüche

1. Vorrichtung zur dosierten Abgabe einer Flüssigkeit wie Klebstoff oder dergleichen, mit einem Ansaugkanal (20), über den die Flüssigkeit zugeführt wird, und einem Abgabekanal (21), über den die Flüssigkeit abgegeben wird und einem in zwei Stellungen betreibbaren Ventil (17), **dadurch gekennzeichnet, dass** ein einziger Kanal (4) vorhanden ist, dessen Endbereiche (5, 6) mittels des Ventils (17) wechselweise mit dem Ansaugkanal (20) oder dem Abgabekanal (21) verbindbar sind, und dass zur dosierten Abgabe der Flüssigkeit ein Schieber (2) im Kanal (4) zwischen zwei Positionen (E, F) hin- und herbewegbar ist.

2. Vorrichtung nach Anspruch 1, **dadurch gekennzeichnet, dass** der Kanal (4) kreisförmig und der Schieber (2) um eine Drehachse (A) drehbar sind.

3. Vorrichtung nach Anspruch 1 oder 2, **dadurch gekennzeichnet, dass** die Vorrichtung einen Körper (1) und eine Deckplatte (3) aufweist, und dass der Schieber (2) in eine Bohrung (14) des Körpers (1) steckbar ist.

4. Vorrichtung nach Anspruch 3, **dadurch gekennzeichnet, dass** der Schieber (2) oder der Körper (1) oder die Deckplatte (3) mit wenigstens einer Ausnehmung (15; 16) versehen ist zur Verkleinerung der Fläche, an der sich der Schieber (2) und der Körper (1) bzw. der Schieber (2) und die Deckplatte (3) berühren.

5. Vorrichtung nach einem der Ansprüche 1 bis 4, **dadurch gekennzeichnet dass** der Kanal (4) eine Ausbuchtung (10) aufweist.

6. Vorrichtung nach einem der Ansprüche 1 bis 5, **dadurch gekennzeichnet, dass** der Schieber (2) aus Kunststoff besteht.

7. Vorrichtung nach einem der Ansprüche 3 bis 5, **dadurch gekennzeichnet, dass** der Körper (1), der Schieber (2) und die Deckplatte (3) aus Kunststoffen bestehen.

8. Schreibkopf (24) mit einer Vorrichtung nach einem der Ansprüche 1 bis 7, **dadurch gekennzeichnet, dass** die Vorrichtung auf dem Schreibkopf (24) montiert ist und dass der Abgabekanal (21) als Schreibdüse ausgebildet ist.
